# EUROPÄISCHE PATENTSCHRIFT

(11) **EP 2 191 547 B1**
(45) Veröffentlichungstag und Bekanntmachung des Hinweises auf die Patenterteilung: **18.11.2015**
(21) Anmeldenummer: 08801251.3
(22) Anmeldetag: 29.08.2008
(51) Int. Cl.: B82Y 20/00, H01S 5/026, H01S 5/34, H01S 5/40, H01S 5/04

(54) **OPTOELEKTRONISCHES BAUELEMENT**
OPTOELECTRONIC COMPONENT
COMPOSANT OPTOÉLECTRONIQUE

(30) Priorität: 24.09.2007 DE 102007045463; 07.12.2007 DE 102007058952
(43) Veröffentlichungstag der Anmeldung: 02.06.2010
(73) Patentinhaber: OSRAM Opto Semiconductors GmbH, 93055 Regensburg (DE)
(72) Erfinder: SABATHIL, Matthias, 93059 Regensburg (DE); BRICK, Peter, 93051 Regensburg (DE); EICHLER, Christoph, 93105 Tegernheim (DE)
(74) Vertreter: Epping - Hermann - Fischer
(86) Internationale Anmeldenummer: PCT/DE2008/001444
(87) Internationale Veröffentlichungsnummer: WO 2009/039814

(56) Entgegenhaltungen:
- EP-A- 1 615 306
- DE-A1- 10 129 616
- US-A1- 2003 026 312
- US-B1- 6 239 901

## Beschreibung

Die vorliegende Anmeldung betrifft ein optoelektronisches Bauelement.

Bei Halbleiterlaserdioden, die auf nitridischen Verbindungshalbleitern basieren, nimmt die Effizienz der Strahlungserzeugung mit zunehmender Wellenlänge meist ab. Dies erschwert die Erzeugung von Strahlung im grünen Spektralbereich. Bislang wird daher grüne Laserstrahlung oftmals dadurch erzeugt, dass Laserstrahlung im infraroten Spektralbereich mittels nichtlinear-optischer Kristalle frequenzverdoppelt wird. Dies ist mit einem vergleichsweise großen Justage- und Montageaufwand verbunden. Hinzu kommen die Kosten für solche Kristalle und vergleichsweise geringe Konversionseffizienzen.

Eine Aufgabe ist es, ein optoelektronisches Bauelement anzugeben, dessen Emissionsstrahlung in einem Spektralbereich liegt, der mit herkömmlichen Halbleiterlaserdioden nicht unmittelbar abgedeckt werden kann.

Diese Aufgabe wird durch den Gegenstand des Patentanspruchs 1 gelöst. Vorteilhafte Ausgestaltungen und Weiterbildungen sind Gegenstand der abhängigen Patentansprüche.

Gemäß einer Ausführungsform weist das optoelektronische Bauelement einen Halbleiterkörper mit einer Halbleiterschichtenfolge auf, wobei die Halbleiterschichtenfolge einen zur Erzeugung einer Pumpstrahlung vorgesehenen Pumpbereich und einen zur Erzeugung einer Emissionsstrahlung vorgesehenen Emissionsbereich aufweist. Der Pumpbereich und der Emissionsbereich sind übereinander angeordnet. Die Pumpstrahlung pumpt den Emissionsbereich im Betrieb des optoelektronischen Bauelementes optisch. Im Betrieb des optoelektronischen Bauelementes tritt die Emissionsstrahlung in lateraler Richtung aus dem Halbleiterkörper aus. Mittels der Pumpstrahlung kann im Emissionsbereich Strahlung vereinfacht erzeugt werden, deren Peak-Wellenlänge in einem für herkömmliche Halbleiterlaserdioden schwer zugänglichen Spektralbereich liegt. Die im Emissionsbereich erzeugte Strahlung ist vorzugsweise kohärent.

Im Betrieb des optoelektronischen Bauelements wird der Pumpbereich vorzugsweise elektrisch gepumpt. Elektrische Leistung wird also zumindest teilweise in optische Leistung in Form der Pumpstrahlung und nachfolgend in Emissionsstrahlung umgewandelt.

Die Emissionsstrahlung und die Pumpstrahlung propagieren vorzugsweise in lateraler Richtung. Die Pumpstrahlung kann also ebenso wie die Emissionsstrahlung im Halbleiterkörper in lateraler Richtung verlaufen. Unter einer lateralen Richtung wird hierbei eine Richtung verstanden, die in einer Haupterstreckungsebene der Halbleiterschichten der Halbleiterschichtenfolge verläuft. Weiterhin können der Emissionsbereich und der Pumpbereich in einem gemeinsamen Wellenleiter angeordnet sein.

In einer bevorzugten Weiterbildung sind der Emissionsbereich und der Pumpbereich zwischen zwei Mantelschichten angeordnet. Die Mantelschichten weisen weiterhin bevorzugt jeweils einen Brechungsindex auf, der niedriger ist als diejenigen der Halbleiterschichten, die jeweils auf der dem Pumpbereich und dem Emissionsbereich zugewandten Seite der Mantelschichten angeordnet sind. Die Mantelschichten können so eine gleichzeitige transversale Wellenführung der Pumpstrahlung und der Emissionsstrahlung bewirken.

In einer bevorzugten Ausgestaltung werden im Betrieb des optoelektronischen Bauelements Ladungsträger eines Ladungstyps, also Elektronen oder Löcher, durch den Emissionsbereich hindurch in den Pumpbereich injiziert. Vorzugsweise sind für die Injektion von Ladungsträgern eine erste Kontaktschicht und eine zweite Kontaktschicht vorgesehen, wobei der Emissionsbereich und der Pumpbereich zwischen diesen Kontaktschichten angeordnet sind. Durch die Anordnung des Emissionsbereichs zwischen der ersten Kontaktschicht und der zweiten Kontaktschicht kann das optoelektronische Bauelement besonders kompakt ausgebildet sein. Weiterhin wird eine optische Kopplung des Emissionsbereichs mit der Pumpstrahlung vereinfacht.

Eine Peak-Wellenlänge der Emissionsstrahlung ist zweckmäßigerweise größer als eine Peak-Wellenlänge der Pumpstrahlung. Eine effiziente Absorption der Pumpstrahlung im Emissionsbereich wird so gewährleistet.

In einer Ausgestaltungsvariante liegt die Peak-Wellenlänge der Emissionsstrahlung und/oder die Peak-Wellenlänge der Pumpstrahlung im ultravioletten oder im sichtbaren Spektralbereich. Beispielsweise können die Peak-Wellenlänge der Pumpstrahlung im blauen oder ultravioletten Spektralbereich und die Emissionsstrahlung im grünen Spektralbereich liegen. Unter dem grünen Spektralbereich wird insbesondere der Bereich zwischen einschließlich 490 nm und einschließlich 570 nm verstanden. Der ultraviolette Spektralbereich umfasst etwa den Wellenlängenbereich von 1 nm bis 380 nm.

Weiterhin kann die Peak-Wellenlänge der Emissionsstrahlung zwischen einschließlich 480 nm und einschließlich 600 nm betragen.

Der Emissionsbereich und/oder der Pumpbereich enthält vorzugsweise ein III-V-Halbleitermaterial. Insbesondere kann der Emissionsbereich und/oder der Pumpbereich AlₓIn_{y}Ga_{1-x-y}N mit 0 ≤ x ≤ 1, 0 ≤ y ≤ 1 und x + y ≤ 1 enthalten. Dieses Halbleitermaterial ist für die Erzeugung von Strahlung im ultravioletten und sichtbaren, insbesondere blauen und grünen, Spektralbereich besonders geeignet.

In einer alternativen Ausgestaltungsvariante liegen die Peak-Wellenlänge der Emissionsstrahlung und/oder die Peak-Wellenlänge der Pumpstrahlung im infraroten oder roten Spektralbereich. Insbesondere für die Erzeugung von Strahlung im roten und infraroten Spektralbereich kann der Emissionsbereich und/oder der Pumpbereich AlₓIn_{y}Ga_{1-x-y}Sb, AlₓIn_{y}Ga_{1-x-y}As oder AlₓIn_{y}Ga_{1-x-y}P, jeweils mit 0 ≤ x ≤ 1, 0 ≤ y ≤ 1 und x + y ≤ 1, enthalten.

Alternativ oder ergänzend können der Emissionsbereich und/oder der Pumpbereich ein III-V-Halbleitermaterial, beispielsweise InGaAsN, mit einem Stickstoffgehalt von höchstens 5 % enthalten. Derartige Halbleitermaterialien werden auch als "verdünnte Nitride" bezeichnet.

In einer bevorzugten Ausgestaltung weist der Emissionsbereich und/oder der Pumpbereich eine Quantenstruktur auf. Die Bezeichnung Quantenstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantenstruktur keine Angabe über die Dimensionalität der Quantisierung. Sie umfasst somit unter anderem Quantentröge, Quantendrähte und Quantenpunkte und jede Kombination dieser Strukturen.

In einer bevorzugten Weiterbildung entspricht eine Bandlücke einer an die Quantenschicht angrenzenden Halbleiterschicht, etwa einer Barriereschicht zwischen zwei benachbarten Quantenschichten, einer an die Quantenschicht des Pumpbereichs angrenzenden Halbleiterschicht. An die Quantenschichten in dem Emissionsbereich und dem Pumpbereich kann also, insbesondere hinsichtlich deren Materialkomposition, jeweils gleichartig ausgeführtes Halbleitermaterial angrenzen. Die Ausbildung eines Emissionsbereichs und eines Pumpbereichs mit hoher Kristallqualität wird so vereinfacht.

In einer bevorzugten Ausgestaltung ist im Halbleiterkörper eine Ladungsträgerbarriere ausgebildet. Die Ladungsträgerbarriere weist vorzugsweise für den einen Ladungstyp eine höhere Durchlässigkeit auf als für den anderen Ladungstyp. Die Ladungsträgerbarriere kann also als eine Löcherbarriere oder als eine Elektronenbarriere ausgeführt sein. Beim elektrischen Pumpen des Pumpbereichs kann so verbessert erzielt werden, dass die strahlende Rekombination von Elektron-Loch-Paaren überwiegend im Pumpbereich erfolgt.

Eine Ladungsträgerbarriere, die in einem n-leitend dotierten Bereich des Halbleiterkörpers oder an einen n-leitend dotierten Bereich des Halbleiterkörpers angrenzend angeordnet ist, ist vorzugsweise als Löcherbarriere ausgeführt.

Entsprechend ist eine Ladungsträgerbarriere, die in einem p-leitend dotierten Bereich des Halbleiterkörpers oder an einen p-leitend dotierten Bereich des Halbleiterkörpers angrenzend angeordnet ist, vorzugsweise als Elektronenbarriere ausgeführt.

Eine Löcherbarriere kann beispielsweise mittels einer Halbleiterschicht gebildet sein, deren Valenzbandkante unterhalb der Valenzbandkante der angrenzenden Halbleiterschichten liegt. Entsprechend kann eine Elektronenbarriere mittels einer Halbleiterschicht gebildet sein, deren Leitungsbandkante oberhalb der Leitungsbandkante der angrenzenden Halbleiterschichten liegt.

Alternativ oder ergänzend kann die Ladungsträgerbarriere als eine Tunnelbarriere ausgeführt sein. Vorzugsweise weist die Tunnelbarriere eine Bandlücke auf, die größer ist als die Bandlücke des angrenzenden Halbleitermaterials.

Die Tunnelbarriere weist vorzugsweise eine Dicke von höchstens 10 nm, besonders bevorzugt von höchstens 5 nm, beispielsweise 2 nm, auf. Ladungsträger können diese Tunnelbarriere in Folge des quantenmechanischen Tunneleffekts überwinden. Die Tunnelwahrscheinlichkeit ist hierbei für Ladungsträger unterschiedlichen Leitungstyps meist unterschiedlich. Die Durchlässigkeit ist daher für einen Ladungstyp, meist Elektronen, höher als für den anderen Ladungstyp.

In einer bevorzugten Weiterbildung ist auf der der Ladungsträgerbarriere abgewandten Seite des Pumpbereichs eine weitere Ladungsträgerbarriere angeordnet. Hierbei ist zweckmäßigerweise die Ladungsträgerbarriere als Löcherbarriere und die weitere Ladungsträgerbarriere als Elektronenbarriere ausgeführt oder umgekehrt. Die Rekombination von Elektron-Loch-Paaren kann so besonders effizient auf den Pumpbereich beschränkt werden. Die Konversionseffizienz von elektrischer Leistung in Pumpstrahlung kann so weitergehend gesteigert werden.

Die Ladungsträgerbarriere kann zwischen dem Pumpbereich und dem Emissionsbereich ausgebildet sein. Eine Rekombination von injizierten Ladungsträgern kann so vereinfacht auf den Pumpbereich beschränkt werden. Alternativ kann die Ladungsträgerbarriere auch auf der dem Emissionsbereich abgewandten Seite des Pumpbereichs angeordnet sein.

In einer bevorzugten Ausgestaltung sind die Schichtdicken der Halbleiterschichten der Halbleiterschichtenfolge derart ausgeführt, dass ein vorgegebener Anteil der Pumpstrahlung mit dem Emissionsbereich optisch koppelt. Insbesondere ist der Kopplungsgrad der Pumpstrahlung mit dem Emissionsbereich durch eine geeignete Anordnung des Emissionsbereiches relativ zu der sich im Betrieb des optoelektronischen Bauelementes in vertikaler ausbildenden optischen Mode der Pumpstrahlung einstellbar.

In einer Ausgestaltungsvariante sind der Emissionsbereich und der Pumpbereich in vertikaler, also transversaler, Richtung jeweils für den Betrieb in einer optischen Mode derselben Ordnung vorgesehen. Insbesondere können der Emissionsbereich und der Pumpbereich in vertikaler Richtung jeweils für den Betrieb in der optischen Grundmode vorgesehen sein.

Weiterhin bevorzugt ist ein Abstand zwischen dem Emissionsbereich und dem Pumpbereich derart eingestellt, dass ein vorgegebener Anteil der Pumpstrahlung mit dem Emissionsbereich optisch koppelt. Je kleiner der Abstand des Emissionsbereiches von einem Intensitätsmaximum der optischen Mode, insbesondere dem einzigen Intensitätsmaximum im Falle der optischen Grundmode, der Pumpstrahlung ist, desto stärker ist die optische Kopplung des Emissionsbereiches mit der Pumpstrahlung.

Der Emissionsbereich und der Pumpbereich können in vertikaler Richtung auch für den Betrieb in transversalen optischen Moden mit voneinander verschiedenen Ordnungen vorgesehen sein. Insbesondere können der Emissionsbereich für den Betrieb in der Grundmode und der Pumpbereich für den Betrieb in einer Mode erster Ordnung vorgesehen sein.

Eine optische Mode n-ter Ordnung zeichnet sich durch ein stehendes Strahlungsfeld mit n Knoten aus. Ein Knoten der optischen Mode des Pumpbereiches und/oder des Emissionsbereiches kann im Bereich einer absorbierenden Schicht ausgebildet sein. Eine ungewollte Absorption der Pumpstrahlung beziehungsweise der Emissionsstrahlung in der absorbierenden Schicht kann so vermindert werden.

Der Halbleiterkörper weist vorzugsweise eine Strahlungsdurchtrittsfläche auf. Durch die Strahlungsdurchtrittsfläche können die Emissionsstrahlung und gegebenenfalls auch die Pumpstrahlung, insbesondere kollinear, hindurch treten.

In einer bevorzugten Ausgestaltung ist auf der Strahlungsdurchtrittsfläche eine Auskoppelschicht ausgebildet. Die Auskoppelschicht kann auch mehrschichtig ausgebildet sein. Insbesondere kann die Auskoppelschicht als ein Bragg-Spiegel ausgeführt sein. Mittels eines Bragg-Spiegels kann die Reflektivität für die Emissionsstrahlung und die Reflektivität für die Pumpstrahlung in weiten Bereichen separat voneinander eingestellt werden.

Bevorzugt ist die Strahlungsdurchtrittsfläche, insbesondere mittels der Auskoppelschicht, derart ausgebildet, dass sie für die Emissionsstrahlung eine niedrigere Reflektivität aufweist als für die Pumpstrahlung. Insbesondere kann die Strahlungsdurchtrittsfläche eine Reflektivität von höchstens 70 %, bevorzugt höchstens 50 %, und für die Pumpstrahlung eine Reflektivität von mindestens 70 % aufweisen. Insbesondere für den Fall, dass die Pumpstrahlung nicht zur Auskopplung aus dem optoelektronischen Bauelement vorgesehen ist, kann die Reflektivität für die Pumpstrahlung auch 80 % oder mehr, bevorzugt 90 % oder mehr betragen.

In einer bevorzugten Weiterbildung ist eine der Strahlungsdurchtrittsfläche gegenüberliegende Fläche des Halbleiterkörpers, beispielsweise mittels einer Reflexionsschicht, derart ausgebildet, dass sie für die Emissionsstrahlung und für die Pumpstrahlung eine Reflektivität von mindestens 50 %, bevorzugt mindestens 70 %, besonders bevorzugt mindestens 90 % aufweist.

In einer bevorzugten Weiterbildung ist ein Resonator für die Emissionsstrahlung und/oder für die Pumpstrahlung mittels eines externen Spiegels gebildet. Die Emissionsstrahlung durchläuft hierbei zwischen dem Emissionsbereich und dem externen Spiegel einen Freistrahlbereich.

Die Pumpstrahlung und die Emissionsstrahlung können weiterhin in Resonatoren propagieren, die voneinander verschieden sind. Insbesondere können die Resonatoren hinsichtlich des Resonatortyps und/oder der Resonatorlänge verschiedenartig ausgebildet sein. Beispielsweise kann die Pumpstrahlung in einem linearen Resonator propagieren, während die Emissionsstrahlung in einem Ring-Resonator propagiert oder umgekehrt.

In einer weiteren bevorzugten Ausgestaltung weist das optoelektronische Bauelement ein nichtlinear-optisches Element auf. Das nichtlinear-optische Element kann zur Frequenzmischung, insbesondere zur Frequenzvervielfachung, etwa der Frequenzverdopplung, der Emissionsstrahlung vorgesehen sein. Weiterhin kann das nichtlinear-optische Element innerhalb des externen Resonators für die Emissionsstrahlung angeordnet sein. Eine Konversion der vom Emissionsbereich abgestrahlten Strahlung, beispielsweise vom grünen Spektralbereich in den ultravioletten Spektralbereich, kann so besonders effizient erfolgen.

In einer weiteren bevorzugten Ausgestaltung umfasst das optoelektronische Bauelement einen Strahlungsempfänger. Der Strahlungsempfänger weist vorzugsweise eine weitere Halbleiterschichtenfolge auf. Der Schichtaufbau dieser weiteren Halbleiterschichtenfolge kann zumindest teilweise dem Schichtaufbau der Halbleiterschichtenfolge entsprechen. Insbesondere können die Halbleiterschichtenfolge mit dem Emissionsbereich und dem Pumpbereich und die weitere Halbleiterschichtenfolge des Strahlungsempfängers in einem gemeinsamen Abscheideschritt, beispielsweise epitaktisch, hergestellt sein und weiterhin bevorzugt aus einer gemeinsamen Halbleiterschichtenfolge hervorgehen. Die Herstellung wird dadurch vereinfacht. Weiterhin können die Halbleiterschichtenfolge mit dem Emissionsbereich und dem Pumpbereich und die weitere Halbleiterschichtenfolge auf einem gemeinsamen Aufwachssubstrat für diese Halbleiterschichtenfolgen angeordnet sein.

Mittels des Strahlungsempfängers kann beispielsweise die Intensität der Emissionsstrahlung und/oder der Pumpstrahlung überwacht werden. Auf ein zusätzliches optoelektronisches Bauteil kann hierfür verzichtet werden.

In einer bevorzugten Ausgestaltung ist auf oder in dem Halbleiterkörper mit dem Emissionsbereich und dem Pumpbereich eine laterale Strukturierung ausgebildet. Mittels einer derartigen lateralen Strukturierung kann beispielsweise in lateraler, also longitudinaler, Richtung ein monomodiger Betrieb erzielt werden. Die laterale Struktur kann beispielsweise eine DFB (distributed feedback)-Struktur oder eine DBR (distributed Bragg reflector)-Struktur sein.

Weitere Merkmale, vorteilhafte Ausgestaltungen und Zweckmäßigkeiten ergeben sich aus der folgenden Beschreibung der Ausführungsbeispiele in Verbindung mit den Figuren.

Es zeigen:
Figur 1 ein erstes Ausführungsbeispiel für ein optoelektronisches Bauelement in schematischer Schnittansicht,
Figur 2 einen Verlauf von Leitungs- und Valenzbandkante für einen Ausschnitt eines Halbleiterkörpers gemäß einem zweiten Ausführungsbeispiel für ein optoelektronisches Bauelement,
die Figuren 3A und 3B jeweils einen Verlauf von Leitungs- und Valenzbandkante für einen Ausschnitt eines Halbleiterkörpers gemäß einem dritten Ausführungsbeispiel (Figur 3A) und einem vierten Ausführungsbeispiel (Figur 3B) für ein optoelektronisches Bauelement,
Figur 4 Ergebnisse einer Simulation des vertikalen Verlaufs von Leitungs- und Valenzbandkante sowie der Rate für eine strahlende Rekombination R_{S} in einem Ausschnitt des Halbleiterkörpers gemäß dem vierten Ausführungsbeispiel des optoelektronischen Bauelements,
Die Figuren 5A und 5B jeweils Ergebnisse von Simulationen der emittierten Strahlungsleistung P als Funktion des injizierten Stroms I für Ausführungsbeispiele des optoelektronischen Bauelements mit verschiedenen thermischen Widerständen,
die Figuren 6A bis 6C jeweils einen qualitativen vertikalen Verlauf von Brechungsindex, optischer Mode der Pumpstrahlung und optischer Mode der Emissionsstrahlung für drei Ausführungsbeispiele des optoelektronischen Bauelements,
Figur 7 Ergebnisse einer Simulation eines Leitungsbandkantenverlaufs, eines Fermi-Niveaus, und einer Elektronendichte in vertikaler Richtung für das vierte Ausführungsbeispiel des optoelektronischen Bauelements,
Figur 8 ein Ergebnis einer Simulation der Stromdichte j als Funktion der Spannung U für das der Figur 7 zugrunde liegende vierte Ausführungsbeispiel des optoelektronischen Bauelements,
Figur 9 Ergebnisse von Simulationen der Reflektivität R einer Auskoppelschicht als Funktion der Wellenlänge λ für zwei Ausführungsbeispiele einer Auskoppelschicht,
Figur 10 ein fünftes Ausführungsbeispiel eines optoelektronischen Bauelements in schematischer Seitenansicht, und
Figur 11 ein sechstes Ausführungsbeispiel eines optoelektronischen Bauelements in schematischer Seitenansicht.

Gleiche, gleichartige und gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

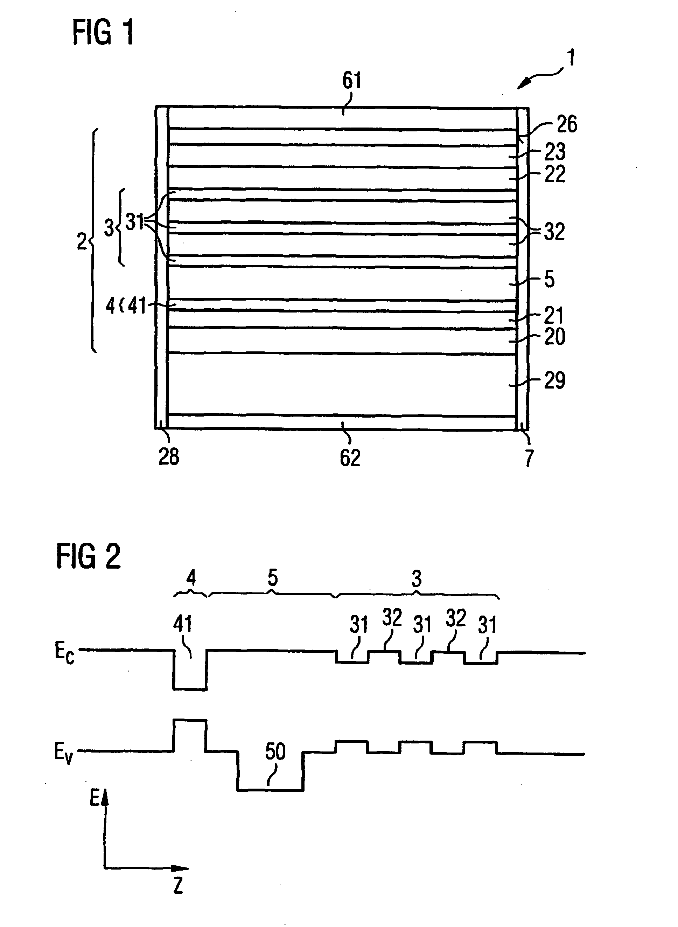

Ein erstes Ausführungsbeispiel für ein optoelektronisches Bauelement 1 ist in schematischer Schnittansicht in Figur 1 dargestellt. Das optoelektronische Bauelement 1 weist einen Halbleiterkörper 2 mit einer Halbleiterschichtenfolge auf. Die Halbleiterschichtenfolge bildet den Halbleiterkörper und ist vorzugsweise epitaktisch, etwa mittels MOVPE oder MBE, hergestellt. Die Halbleiterschichtenfolge des Halbleiterkörpers weist einen zur Erzeugung einer Pumpstrahlung vorgesehenen Pumpbereich 3 und einen zur Erzeugung einer Emissionsstrahlung vorgesehenen Emissionsbereich 4 auf. Der Pumpbereich und der Emissionsbereich sind übereinander angeordnet.

Im Betrieb des optoelektronischen Bauelements pumpt die Pumpstrahlung den Emissionsbereich 4 optisch. Die so erzeugte Emissionsstrahlung tritt in lateraler Richtung aus dem Halbleiterkörper aus. Die Emissionsstrahlung und die Pumpstrahlung propagieren in lateraler Richtung.

Der Halbleiterkörper 2 mit der Halbleiterschichtenfolge ist auf einem Träger 29 angeordnet. Der Träger kann beispielsweise ein Aufwachssubstrat für die Halbleiterschichtenfolge des Halbleiterkörpers 2 sein. Alternativ kann der Träger 29 auch von dem Aufwachssubstrat verschieden sein. In diesem Fall muss der Träger nicht die hohen Anforderungen an ein Aufwachssubstrat, insbesondere hinsichtlich der kristallinen Reinheit, erfüllen, sondern kann vielmehr im Hinblick auf andere Eigenschaften wie thermische Leitfähigkeit, elektrische Leitfähigkeit und/oder mechanische Stabilität ausgewählt werden.

Das optoelektronische Bauelement 1 weist weiterhin eine erste Kontaktschicht 61 und eine zweite Kontaktschicht 62 auf. Die erste und die zweite Kontaktschicht sind derart angeordnet, dass im Betrieb des optoelektronischen Bauelements über diese Kontaktschichten Ladungsträger von verschiedenen Seiten in den Pumpbereich 3 injiziert werden können und dort durch Rekombination von Elektron-Loch-Paaren Strahlung erzeugen. Die Kontaktschichten enthalten vorzugsweise jeweils ein Metall, etwa Au, Ag, Ti, Pt, Al oder Ni, oder eine metallische Legierung mit zumindest einem der genannten Metalle.

Der Pumpbereich 3 wird also vertikal elektrisch gepumpt, während die Pumpstrahlung, die den Emissionsbereich 4 optisch pumpt, in lateraler Richtung propagiert.

Der Pumpbereich 3 weist exemplarisch drei Quantenschichten 31 auf, zwischen denen jeweils eine Barriereschicht 32 angeordnet ist. Auch eine von drei abweichende Anzahl von Quantenschichten, etwa eine Quantenschicht, zwei Quantenschichten oder vier oder mehr Quantenschichten können in dem Pumpbereich ausgebildet sein.

Weiterhin weist der Emissionsbereich 4 eine Quantenschicht 41 auf. Davon abweichend kann der Emissionsbereich auch zwei oder mehr Quantenschichten umfassen. Die Quantenschicht beziehungsweise die Quantenschichten des Emissionsbereichs 4 sind zweckmäßigerweise derart ausgeführt, dass eine Übergangsenergie von Elektron-Loch-Paaren in der Quantenschicht des Emissionsbereichs kleiner ist als eine Übergangsenergie in den Quantenschichten 31 des Pumpbereichs 3. Im Pumpbereich erzeugte Pumpstrahlung kann so effizient im Emissionsbereich absorbiert werden.

Im Betrieb des optoelektronischen Bauelements werden Ladungsträger eines Ladungstyps durch den Emissionsbereich 4 hindurch in den Pumpbereich 3 injiziert. In dem gezeigten Ausführungsbeispiel ist der Emissionsbereich im Injektionspfad der Ladungsträger von der zweiten Kontaktschicht 62 in den Pumpbereich 3 angeordnet.

Zweckmäßigerweise sind die Halbleiterschichten auf der einen Seite des Pumpbereichs zumindest teilweise n-leitend dotiert und auf der anderen Seite des Pumpbereichs zumindest teilweise p-leitend dotiert. Die Injektion von Ladungsträgern in den Pumpbereich von zwei verschiedenen Seiten des Pumpbereichs wird so vereinfacht.

Beispielsweise kann zwischen dem Pumpbereich 4 und dem Träger 29 eine n-leitende Halbleiterschicht 21 und eine n-leitende Mantelschicht 20 angeordnet sein. Auf der dem Träger abgewandten Seite des Pumpbereichs 4 können entsprechend p-dotierte Halbleiterschichten 22, 24 sowie eine p-leitende Mantelschicht 23 angeordnet sein. Die Mantelschichten weisen zweckmäßigerweise einen Brechungsindex auf, der niedriger ist als der Brechungsindex der zwischen den Mantelschichten angeordneten Halbleiterschichten. Der Emissionsbereich und der Pumpbereich sind zwischen diesen Mantelschichten angeordnet. Eine gemeinsame transversale Wellenführung der Pumpstrahlung und der Emissionsstrahlung zwischen den Mantelschichten wird so vereinfacht.

Der Emissionsbereich 4 und der Pumpbereich 3 sind vorzugsweise zumindest teilweise in einem gleichartig dotierten Bereich des Halbleiterkörpers angeordnet. Insbesondere kann der Emissionsbereich vollständig und der Pumpbereich vollständig oder zumindest teilweise in einem n-leitend dotierten Bereich angeordnet sein.

Die Halbleiterschichten des Emissionsbereichs 4 und des Pumpbereichs 3 können bezüglich ihrer Materialzusammensetzung in weiten Grenzen variiert werden.

Bevorzugt enthält der Emissionsbereich 4 und/oder der Pumpbereich 3 ein III-V-Verbindungshalbleitermaterial. Für die Erzeugung grüner Emissionsstrahlung eignet sich insbesondere ein nitridisches Verbindungshalbleitermaterial, das vorzugsweise auf der Materialzusammensetzung AlₓIn_{y}Ga_{1-x-y}N mit 0 ≤ x ≤ 1, 0 ≤ y ≤ 1 und x + y ≤ 1, basiert. Eine exemplarische Materialzusammensetzung für den in Figur 1 dargestellten Schichtaufbau ist in Tabelle 1 gezeigt, wobei der Emissionsbereich für die Erzeugung von Strahlung im grünen Spektralbereich, etwa bei 532 nm, vorgesehen ist.

**Tabelle 1**

| Schicht | Materialzusammensetzung | Schichtdicke |
|---|---|---|
| erste Kontaktschicht 61 | Au | 1000 nm |
| Halbleiterschicht 24 | GaN | 100 nm |
| Mantelschicht 23 | Al_{0.06}Ga_{0.94}N | 600 nm |
| Halbleiterschicht 22 | GaN | 88.58 nm |
| Quantenschicht 31 | In_{0.051}Ga_{0.949}N | 4 nm |
| Barriereschicht 32 | GaN | 8 nm |
| Quantenschicht 31 | In_{0.051}Ga_{0.949}N | 4 nm |
| Barriereschicht 32 | GaN | 8 nm |
| Quantenschicht 31 | In_{0.051}Ga_{0.949}N | 4 nm |
| Zwischenschicht 5 | GaN | 279.11 nm |
| Quantenschicht 41 des Emissionsbereichs 4 | In_{0.10}Ga_{0.90}N | 2 nm |
| Halbleiterschicht 21 | GaN | 420.83 nm |
| Mantelschicht 20 | Al_{0.06}Ga_{0.94}N | 2000 nm |
| Träger | GaN | 90 µm |
| zweite Kontaktschicht 62 | Au | 1000 nm |

Die Peak-Wellenlänge der Emissionsstrahlung ist hierbei durch eine geeignete Kombination der Dicke der Quantenschicht 41 des Emissionsbereichs 4 und deren In-Gehalt einstellbar, wobei die Peak-Wellenlänge durch Erhöhung des In-Gehalts und/oder durch Vergrößerung der Schichtdicke gesteigert werden kann. Für die Erzeugung von Emissionsstrahlung mit einer Wellenlänge von etwa 532 nm eignet sich beispielsweise eine InGaN-Quantenschicht 41 mit einem Indiumgehalt y von 10 % und einer Dicke von 2 nm. Die an diese Quantenschicht 41 angrenzenden Halbleiterschichten 21, 5 basieren jeweils auf GaN und weisen somit eine Bandlücke auf, die größer ist als diejenige der Quantenschicht 41. Der Emissionsbereich kann auch mehr als eine Quantenschicht aufweisen, wobei die Quantenschichten vorzugsweise gleichartig ausgeführt sind.

Für die Quantenschichten 31 des Pumpbereichs 3 eignen sich hierbei Quantenschichten mit einer Dicke von 4 nm und einem Indiumgehalt y von etwa 5,1 %. Die Barriereschichten 32 basieren wiederum auf GaN, weisen also dieselbe Zusammensetzung auf wie die Halbleiterschichten 21, 5, die an die Quantenschicht 41 des Emissionsbereichs 4 angrenzen. Der Pumpbereich weist drei Quantenschichten 31 auf. Davon abweichend können aber auch eine Quantenstruktur mit nur einer, zwei oder mehr als drei Quantenschichten vorgesehen sein.

Die Quantenschichten 31 des Pumpbereichs 3 weisen also eine niedrigere Indiumkonzentration auf als die Quantenschicht 41 des Emissionsbereichs 4. Die Injektion von Ladungsträgern in die Quantenschichten des Pumpbereichs 3 wird so, insbesondere verglichen mit der Injektion in die Quantenschichten des Emissionsbereichs 4, vereinfacht.

Die Ursache für eine mit zunehmendem Indiumgehalt erschwerte Injektion von Ladungsträgern in die Quantenschichten sind piezoelektrische Felder, die sich an einer InGaN/GaN-Grenzfläche ausbilden. Je höher der In-Gehalt ist, desto stärker sind diese piezoelektrischen Felder.

Mittels des elektrisch gepumpten Pumpbereichs 3 und des durch diesen optisch gepumpten Emissionsbereichs 4 kann also Strahlung in einem Wellenlängenbereich, beispielsweise in dem grünen Wellenlängenbereich, auf einfache Weise durch Anlegen einer externen elektrischen Spannung erzeugt werden. So kann kohärente Strahlung, etwa Laserstrahlung, im grünen Spektralbereich erzeugt werden, wobei auf eine Konversion in einem nichtlinear-optischen Kristall verzichtet werden kann. Die grüne kohärente Strahlung wird also noch innerhalb des elektrisch gepumpten Halbleiterkörpers 2 erzeugt.

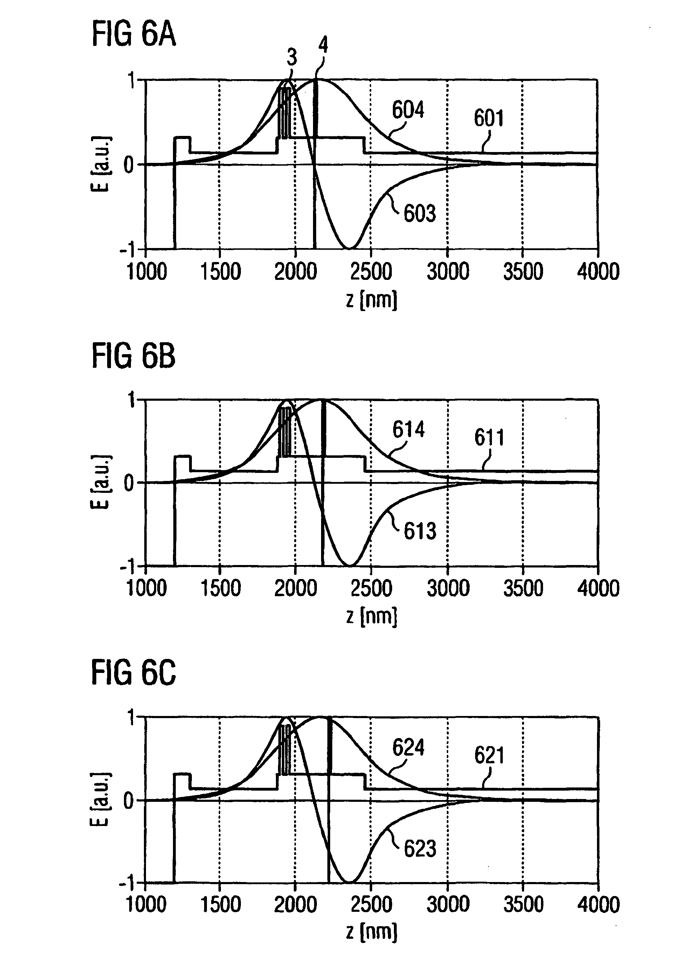

Zwischen dem Pumpbereich 3 und dem Emissionsbereich 4 ist eine Zwischenschicht 5 angeordnet. Mittels dieser Zwischenschicht ist eine optische Kopplung zwischen der Pumpstrahlung und dem Emissionsbereich 4 einstellbar. Die Dicke der Zwischenschicht beträgt vorzugsweise zwischen einschließlich 1 nm und einschließlich 2 µm, besonders bevorzugt zwischen einschließlich 5 nm und 1 µm. Dies wird im Zusammenhang mit den Figuren 6A bis 6C näher ausgeführt.

Durch Einstellen der Schichtdicken und/oder der Materialzusammensetzung können auch andere Emissionswellenlängen erzeugt werden. Bevorzugt liegt die Peak-Wellenlänge der Emissionsstrahlung zwischen einschließlich 480 nm und einschließlich 600 nm. Die Peak-Wellenlänge der Pumpstrahlung liegt vorzugsweise im blauen oder ultravioletten Spektralbereich.

Der Pumpbereich 3 und der Emissionsbereich 4 sind zwischen zwei Mantelschichten 23, 20 angeordnet, die jeweils Al_{0.06}Ga_{0.94}N enthalten und somit einen niedrigeren Brechungsindex aufweisen als die zwischen diesen Mantelschichten 20, 23 angeordneten GaN-Halbleiterschichten, etwa die Barriereschichten 32 des Pumpbereichs 3 oder die an die Mantelschichten 20 und 23 jeweils seitens des Emissionsbereichs und des Pumpbereichs angrenzenden Halbleiterschichten 21 und 22.

Von der beschriebenen Materialzusammensetzung der Schichtfolge abweichend kann der Emissionsbereich und/oder der Pumpbereich ein anderes Halbleitermaterial, insbesondere ein III-V-Halbleitermaterial enthalten. Beispielsweise kann der Emissionsbereich und/oder der Pumpbereich AlₓIn_{y}Ga_{1-x-y}Sb, AlₓInyGa_{1-x-y}As oder AlₓIn_{y}Ga_{1-x-y}P, jeweils mit 0 ≤ x ≤ 1, 0 ≤ y ≤ 1 und x + y ≤ 1 enthalten. Auch ein III-V-Halbleitermaterial, beispielsweise In_{y}Ga_{1-y}As_{1-z}N_{z}, mit einem Stickstoffgehalt z von höchstens 5 % kann Anwendung finden. Durch geeignete Wahl der Halbleitermaterialien und der Halbleiterschichtdicken kann so die Emissionsstrahlung in weiten Bereichen vom ultravioletten über den sichtbaren bis in den nahen oder mittleren Infrarotbereich eingestellt werden. Beispielsweise kann ein Emissionsbereich, der für Strahlungsemission im mittleren Infrarot vorgesehen ist, mittels eines im nahen Infrarot emittierenden Pumpbereichs optisch gepumpt werden.

Der Halbleiterkörper 2 mit der Halbleiterschichtenfolge weist eine Strahlungsdurchtrittsfläche 26 auf. Die Strahlungsdurchtrittsfläche verläuft schräg oder senkrecht zu einer Hauptersteckungsrichtung der Halbleiterschichten der Halbleiterschichtenfolge des Halbleiterkörpers 2 und begrenzt somit den Halbleiterkörper in lateraler Richtung.

Die Strahlungsdurchtrittsfläche 26 kann beispielsweise mittels Spaltens oder Brechens oder mittels Ätzens, etwa nasschemischen oder trockenchemischen Ätzens, hergestellt sein.

Auf der Strahlungsdurchtrittsfläche 26 ist eine Auskoppelschicht 7 ausgebildet, mittels derer die Reflektivität für die Emissionsstrahlung und/oder die Pumpstrahlung an einen vorgegebenen Wert oder an einen vorgegebenen spektralen Verlauf der Reflektivität angepasst ist. Gegebenenfalls kann auf eine Auskoppelschicht auch verzichtet werden. Von gezeigten Ausführungsbeispiel abweichend kann die Auskoppelschicht 7 die Kontaktschichten 61, 62 und/oder den Träger 29 nicht oder nur teilweise bedecken.

Die Auskoppelschicht 7 kann für die Emissionsstrahlung eine geringere Reflektivität aufweisen als für die Pumpstrahlung. Die Auskoppelschicht 7 kann beispielsweise für die Emissionsstrahlung eine Reflektivität von höchstens 70 %, bevorzugt höchstens 50 % und für die Pumpstrahlung eine Reflektivität von mindestens 70 %, bevorzugt mindestens 80 %, besonders bevorzugt mindestens 90 % aufweisen. Insbesondere für den Fall, dass die Pumpstrahlung nicht zur Auskopplung aus dem Halbleiterkörper 2, sondern ausschließlich zum optischen Pumpen des Emissionsbereichs 4 vorgesehen ist, kann die Auskoppelschicht für die Pumpstrahlung auch eine Reflektivität von mindestens 80 %, bevorzugt mindestens 90 %, besonders bevorzugt mindestens 95 %, aufweisen.

Auf der der Strahlungsdurchtrittsfläche 26 gegenüberliegenden Seite des Halbleiterkörpers 2 ist eine Reflexionsschicht 28 ausgebildet. Die Reflexionsschicht weist vorzugsweise für die Pumpstrahlung und für die Emissionsstrahlung eine hohe Reflektivität auf. Die Reflektivität kann mindestens 50 %, bevorzugt mindestens 70 %, besonders bevorzugt mindestens 80 %, am meisten bevorzugt mindestens 90 % betragen.

Die Pumpstrahlung kann auch zumindest teilweise für die Auskopplung aus dem Halbleiterkörper 2 vorgesehen sein. In diesem Fall kann auch eine geringere Reflektivität der Auskoppelschicht 7 für die Pumpstrahlung zweckmäßig sein.

Das optoelektronische Bauelement kann also gleichzeitig die Emissionsstrahlung und die Pumpstrahlung, also zwei Strahlungsanteile mit voneinander verschiedenen Peak-Wellenlängen, beispielsweise Strahlung im blauen und grünen Spektralbereich, zur Verfügung stellen. Die Emissionsstrahlung und die Pumpstrahlung können insbesondere kollinear durch die Strahlungsdurchtrittsfläche hindurch treten. Auf eine aufwändige Überlagerung von Strahlungsanteilen mit verschiedenen Peak-Wellenlängen kann verzichtet werden.

Weiterhin kann die Auskoppelschicht 7 auch mehrschichtig ausgebildet sein. Insbesondere kann mittels einer Mehrzahl von Schichten ein Bragg-Spiegel gebildet werden. Der Bragg-Spiegel ist vorzugsweise mittels dielektrisch ausgebildeter Schichten gebildet. Für die Emissionsstrahlung oder für die Pumpstrahlung können die Schichten zumindest teilweise eine optische Schichtdicke, das heißt, Schichtdicke multipliziert mit Brechungsindex, von etwa einem Viertel der Peak-Wellenlänge der Emissionsstrahlung beziehungsweise der Peak-Wellenlänge der Pumpstrahlung aufweisen.

Die dielektrischen Schichten können auf dem, vorzugsweise vorgefertigten, Halbleiterkörper 2 abgeschieden werden. Dies kann beispielsweise mittels Sputterns oder Aufdampfens erfolgen. Die Auskoppelschicht 7 kann beispielsweise ein Oxid, etwa TiO₂ oder SiO₂, ein Nitrid, etwa Si₃N₄, oder ein Oxinitrid, etwa Siliziumoxinitrid, enthalten. Insbesondere eignen sich für die Auskoppelschicht Schichtenpaare mit einer SiO₂-Schicht und einer Si₃N₄-Schicht.

Die für die Auskoppelschicht beschriebenen Merkmale sind auch auf die Reflexionsschicht 28 anwendbar.

Auf dem oder in dem Halbleiterkörper 2 mit der beschriebenen vertikalen Struktur kann eine laterale Strukturierung ausgebildet sein. Beispielsweise kann die laterale Strukturierung gemäß der Strukturierung eines DFB-Halbleiterlasers oder eines DBR-Halbleiterlasers ausgeführt sein.

Ein schematischer Verlauf einer Leitungsbandkante E_{C} und einer Valenzbandkante E_{V} in einem Teilbereich des Halbleiterkörpers 2, der den Pumpbereich 3 und den Emissionsbereich 4 umfasst, ist in Figur 2 für ein zweites Ausführungsbeispiel eines optoelektronischen Bauelements dargestellt. Dieses zweite Ausführungsbeispiel entspricht im wesentlichen dem im Zusammenhang mit Figur 1 beschriebenen ersten Ausführungsbeispiel.

Die eingetragene z-Richtung steht hierbei senkrecht zu einer Haupterstreckungsrichtung der Halbleiterschichten der Halbleiterschichtenfolge des Halbleiterkörpers 2. Die z-Richtung verläuft somit entlang einer Abscheiderichtung dieser Halbleiterschichten.

Wie im Zusammenhang mit Figur 1 beschrieben, umfassen der Pumpbereich 3 und der Emissionsbereich 4 jeweils eine Quantenstruktur, wobei der Pumpbereich 3 exemplarisch drei Quantenschichten 31 und der Emissionsbereich 4 eine Quantenschicht 41 aufweist. Die Energiedifferenz zwischen Leitungsbandkante und Valenzbandkante ist in der Quantenschicht 41 des Emissionsbereichs 4 geringer als in den Quantenschichten 31 des Pumpbereichs 3. Strahlung, die durch strahlende Rekombination von Elektron-Loch-Paaren in den Quantenschichten 31 des Pumpbereichs 3 erzeugt wird, kann so im Emissionsbereich 4, insbesondere in der Quantenschicht 41, absorbiert werden. Durch Rekombination von Elektron-Loch-Paaren in dem Emissionsbereich 4 kann so kohärente Strahlung mit einer Peak-Wellenlänge erzeugt werden, die größer ist als die Peak-Wellenlänge der Pumpstrahlung. Die dargestellten Verläufe der Leitungs- und Valenzbandkante stellen lediglich schematisch den nominellen Verlauf des Leitungs- und Valenzbandes für die einzelnen Halbleiterschichten dar. Durch Grenzflächeneffekte bedingte Änderungen dieser Verläufe sind in der stark vereinfachten Darstellung nicht berücksichtigt.

Im Unterschied zu dem im Zusammenhang mit Figur 1 beschriebenen Ausführungsbeispiel ist im Halbleiterkörper 2 eine Ladungsträgerbarriere 50 ausgebildet. Die Ladungsträgerbarriere ist zwischen dem Emissionsbereich 4 und dem Pumpbereich 3 angeordnet.

Die Ladungsträgerbarriere 50 ist in der Zwischenschicht 5 ausgebildet, wobei die Ladungsträgerbarriere ein Halbleitermaterial enthält, das eine größere Bandlücke aufweist als das angrenzenden Halbleitermaterial. Beispielsweise kann die Ladungsträgerbarriere in einer GaN-Zwischenschicht als eine AlGaN-Ladungsträgerbarriere mit einem Aluminium-Gehalt zwischen einschließlich 10 % und einschließlich 30 %, bevorzugt zwischen einschließlich 15 % und einschließlich 25 %, ausgeführt sein. Die Dicke der Ladungsträgerbarriere kann beispielsweise zwischen einschließlich 10 nm und einschließlich 50 nm, etwa 20 nm, betragen.

Die Ladungsträgerbarriere 50 weist eine Valenzbandkante auf, die energetisch tiefer liegt als diejenige des angrenzenden Halbleitermaterials. Ein Stromfluss von Löchern von der einen Seite des Pumpbereichs 3 durch den Pumpbereich hindurch bis zum Emissionsbereich 4 kann so vermieden werden. Auf diese Weise wird eine strahlende Rekombination von Ladungsträgern innerhalb des Pumpbereichs 3 gefördert. Die Leitungsbandkante verläuft im Bereich der Ladungsträgerbarriere 50 dagegen auf einer konstanten Höhe, so dass Elektronen die Ladungsträgerbarriere ungehindert zum Pumpbereich hin durchqueren können.

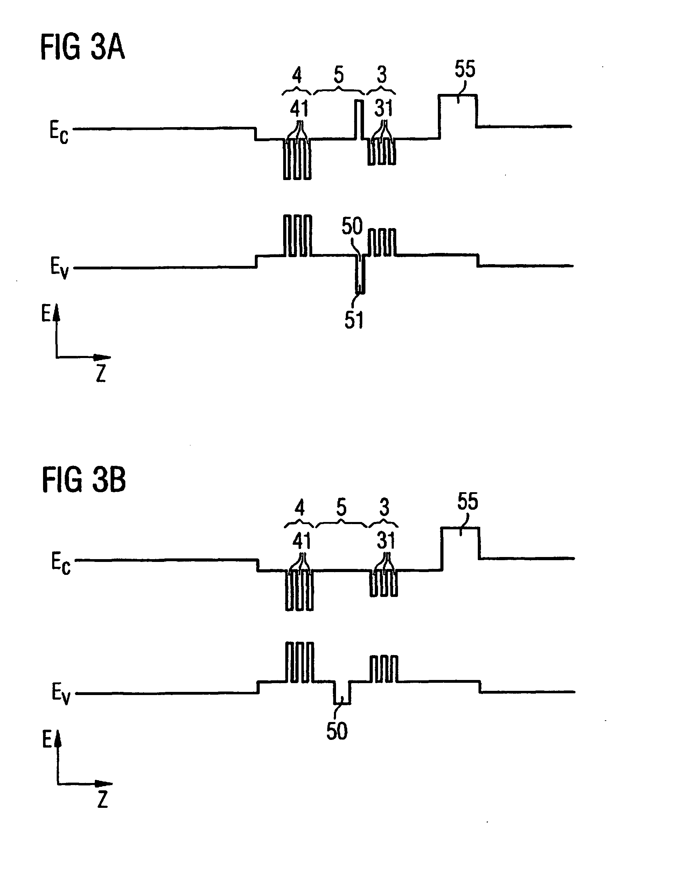

In den Figuren 3A und 3B ist jeweils ein schematischer Verlauf einer Leitungsbandkante E_{C} und einer Valenzbandkante E_{V} in einem Teilbereich des Halbleiterkörpers 2, der den Pumpbereich 3 und den Emissionsbereich 4 umfasst, für ein drittes beziehungsweise für ein viertes Ausführungsbeispiel eines optoelektronischen Bauelements dargestellt. Die Verläufe stellen wie in Figur 2 lediglich schematisch den nominellen Verlauf des Leitungs- und Valenzbandes für die einzelnen Halbleiterschichten dar, wobei Grenzflächeneffekte nicht berücksichtigt sind.

Das in Figur 3A dargestellte dritte Ausführungsbeispiel entspricht im Wesentlichen dem im Zusammenhang mit Figur 2 beschriebenen zweiten Ausführungsbeispiel.

Der Emissionsbereich 4 weist vom zweiten Ausführungsbeispiel abweichend exemplarisch drei Quantenschichten 41 auf.

Weiterhin ist im Unterschied zum zweiten Ausführungsbeispiel zwischen dem Pumpbereich 3 und dem Emissionsbereich 4 eine Ladungsträgerbarriere 50 ausgebildet, die als eine Tunnelbarriere 51 ausgeführt ist.

Bei der Tunnelbarriere 51 liegt die Leitungsbandkante E_{C} energetisch höher als in dem angrenzenden Halbleitermaterial. Gleichzeitig liegt die Valenzbandkante E_{V} energetisch tiefer als in dem angrenzenden Halbleitermaterial. Die Tunnelbarriere weist vorzugsweise eine Dicke von höchstens 10 nm, besonders bevorzugt höchstens 5 nm, etwa 2 nm, auf. Bei einem angrenzenden GaN-Halbleitermaterial eignet sich beispielsweise eine AlGaN-Schicht mit einem Aluminium-Gehalt zwischen einschließlich 30 % und einschließlich 70 % als Tunnelbarriere.

Bei einer derartig ausgeführten Tunnelbarriere ist die Transmissionswahrscheinlichkeit für Löcher geringer als diejenige für Elektronen. Ein Hindurchtreten von Löchern kann so behindert werden, während Elektronen weitgehend ungehindert die Tunnelbarriere passieren können. Die Tunnelbarriere 51 stellt somit eine Löcherbarriere dar.

Auf der dem Emissionsbereich 4 abgewandten Seite des Pumpbereichs 3 ist eine weitere Ladungsträgerbarriere 55 angeordnet, die als Elektronenbarriere ausgeführt ist. Hierbei weist die Elektronenbarriere eine Leitungsbandkante auf, die energetisch höher liegt als diejenige der angrenzenden Halbleiterschichten. Die Valenzbandkante verläuft dagegen weitgehend auf demselben energetischen Niveau wie in dem angrenzenden Halbleitermaterial, so dass Löcher praktisch ungehindert die Elektronenbarriere zum Pumpbereich 3 hin durchqueren können.

Beispielsweise eignet sich als Elektronenbarriere, die an GaN-Halbleitermaterial angrenzt, eine AlGaN-Halbleiterschicht mit einem Aluminium-Gehalt zwischen einschließlich 10 % und einschließlich 30 %, bevorzugt zwischen einschließlich 15 % und einschließlich 25 %. Die Dicke der Elektronenbarriere kann beispielsweise zwischen einschließlich 10 nm und einschließlich 50 nm, etwa 20 nm, betragen.

Der Halbleiterkörper 2 weist also für zwei verschiedene Ladungstypen jeweils eine Ladungsträgerbarriere auf. Auf diese Weise kann die strahlende Rekombination von in den Halbleiterkörper injizierten Ladungsträgern besonders effizient auf den Pumpbereich begrenzt werden.

Von dem gezeigten Ausführungsbeispiel abweichend kann auf die als Löcherbarriere ausgeführte Ladungsträgerbarriere auch verzichtet werden 50. In diesem Fall weist das optoelektronische Bauelement also nur eine Elektronenbarriere auf.

Das dem Figur 3B zugrunde liegende vierte Ausführungsbeispiel für ein optoelektronisches Bauelement entspricht im wesentlichen dem im Zusammenhang mit Figur 3A beschriebenen dritten Ausführungsbeispiel. Im Unterschied hierzu ist die als Löcherbarriere wirkende Ladungsträgerbarriere 50 nicht als Tunnelbarriere ausgeführt. Hierbei kann die Löcherbarriere wie im Zusammenhang mit Figur 2 beschrieben ausgebildet sein.

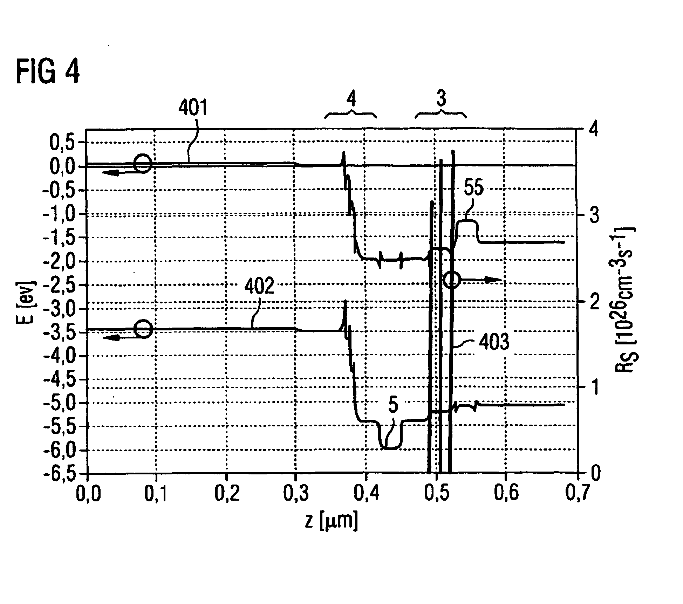

In Figur 4 ist das Ergebnis einer Simulation des Verlaufs der Leitungsbandkante 401 und der Valenzbandkante 402 für das im Zusammenhang mit Figur 3B beschriebene vierte Ausführungsbeispiel des optoelektronischen Bauelements dargestellt. Weiterhin zeigt die Figur den Verlauf der strahlenden Rekombination R_{S} 403 als Funktion des Orts entlang der vertikalen Richtung z.

Mittels der Ladungsträgerbarriere 50 sowie der weiteren Ladungsträgerbarriere 55, die jeweils für Löcher beziehungsweise Elektronen eine Barriere bilden, kann die strahlende Rekombination R_{S} beim elektrischen Pumpen des Halbleiterkörpers 2 besonders effizient auf den Pumpbereich beschränkt werden. Dies zeigt der Verlauf 403 der strahlenden Rekombination R_{S}, der lediglich im Bereich der Quantenschichten des Pumpbereichs 3 von Null verschiedene Werte aufweist.

Im Unterschied zu der Darstellung in der Figur 2 sowie in den Figuren 3A und 3B sind bei den gezeigten simulierten Verläufen von Leitungsband- und Valenzbandkante auch Grenzflächeneffekte wie piezoelektrische Felder berücksichtigt. Dies äußert sich beispielsweise an dem sprunghaften Ansteigen und unmittelbar darauf folgenden Abfallen der Leitungsbandkante an den Grenzflächen zwischen den indiumhaltigen Quantenschichten des Emissionsbereichs 4 und den daran angrenzenden Halbleiterschichten.

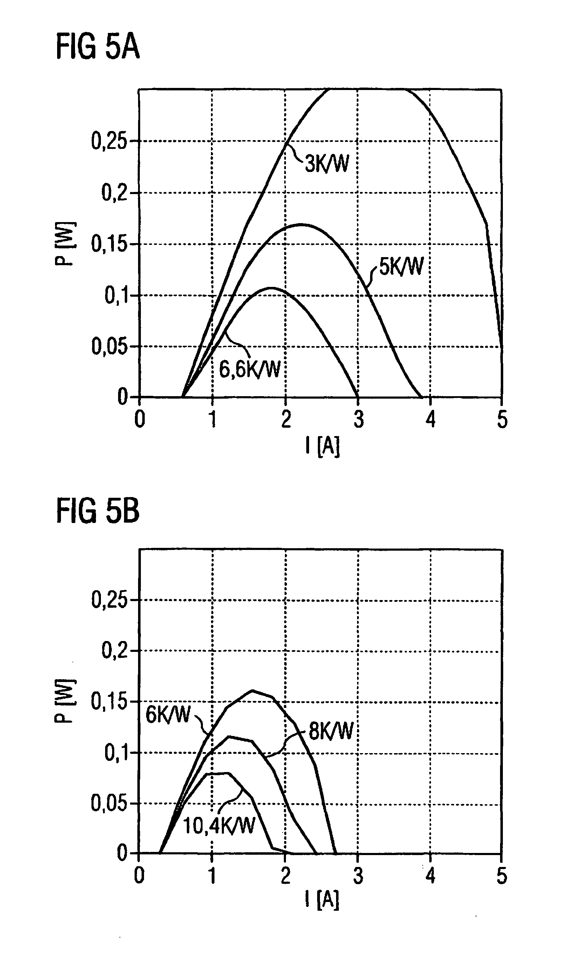

Die Figuren 5A und 5B zeigen jeweils Ergebnisse von Simulationen der Ausgangsleistung P in Abhängigkeit von dem injizierten Strom I für die angegebenen thermischen Widerstände. Hierbei weist der Emissionsbereich für die in Figur 5A dargestellten Kurven eine Breite von 20 µm und für die in Figur 5B dargestellten Kurven eine Breite von 10 µm auf. Die Breite bezieht sich hierbei auf eine in der Haupterstreckungsebene der Halbleiterschichten des Halbleiterkörpers und senkrecht zur Emissionsrichtung verlaufende Ausdehnung des Emissionsbereichs.

Diesen Simulationen liegt eine Struktur zugrunde, die wie im Zusammenhang mit Figur 1 beschrieben ausgeführt ist. Die Pumpstrahlung liegt im ultravioletten Spektralbereich, die Emissionsstrahlung im grünen Spektralbereich. Seitens der Strahlungsdurchtrittsfläche wurde eine Reflektivität von 90 % für den ultravioletten Spektralbereich und 10 % für den grünen Spektralbereich zugrunde gelegt. Die Reflektivität einer der Auskoppelfläche gegenüberliegenden Fläche des Halbleiterkörpers, die ebenfalls eine Resonatorfläche bildet, beträgt für den grünen und den ultravioletten Spektralbereich jeweils eine Reflektivität von 90 %. Gemäß den Simulationen kann die Emissionsstrahlung bei einem thermischen Widerstand von 3 K/W eine Leistung von über 0,25 W aufweisen.

Die Figuren 6A bis 6C zeigen jeweils Ergebnisse von Simulationen des elektromagnetischen Felds 603, 613, 623 der Pumpstrahlung und des elektromagnetischen Felds 604, 614, 624 der Emissionsstrahlung in vertikaler Richtung z.

Die Feldverteilungen sind jeweils normiert dargestellt. Weiterhin zeigen die Kurven 601, 611 und 621 jeweils den qualitativen Verlauf der Brechungsindizes.

Die Figuren 6A bis 6C zeigen jeweils den Fall, dass der Pumpbereich 3 für den Betrieb in der optischen Mode erster Ordnung vorgesehen ist. Der Emissionsbereich 4 ist für den Betrieb in der optischen Grundmode vorgesehen.

Die Halbleiterschichtenfolgen, die den dargestellten Simulationskurven zugrunde liegen, unterscheiden sich dadurch voneinander, dass der Abstand des Emissionsbereichs 4 vom Pumpbereich 3 variiert wird. In Figur 6A ist der Fall dargestellt, dass der Emissionsbereich 4 nahe des Knotens der optischen Mode der Pumpstrahlung angeordnet ist. Eine optische Kopplung zwischen der Pumpstrahlung und dem Emissionsbereich ist so vergleichsweise niedrig. Wie in den Figuren 6B und 6C dargestellt, kann durch eine Variation des Abstands zwischen dem Pumpbereich und dem Emissionsbereich, im gezeigten Fall durch eine Vergrößerung des Abstands, die optische Kopplung zwischen der Pumpstrahlung und dem Emissionsbereich vergrößert werden. Durch eine geeignete Wahl der Schichtdicken der Halbleiterschichten der Halbleiterschichtenfolge, insbesondere durch den Abstand zwischen dem Pumpbereich und dem Emissionsbereich, ist also die Stärke dieser optischen Kopplung einstellbar. Je höher die optische Kopplung ist, desto größer kann der Anteil der Pumpstrahlung sein, der im Emissionsbereich absorbiert wird. Dadurch kann auch die Ausgangsleistung der Emissionsstrahlung gesteigert werden.

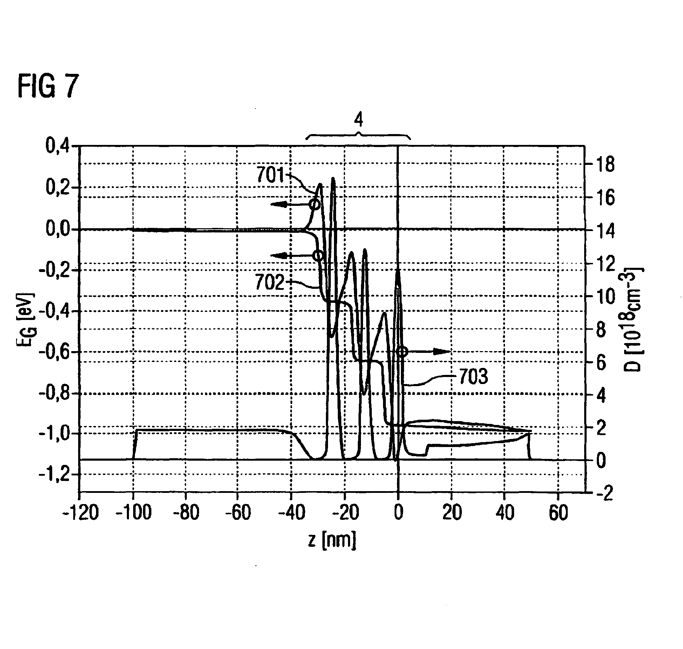

In Figur 7 sind die Ergebnisse von Simulationen des Verlaufs der Leitungsbandkante 701 und des Fermi-Niveaus 702 in vertikaler Richtung dargestellt. Weiterhin zeigt Figur 7 die Elektronendichteverteilung 703. Die Simulationen basieren jeweils auf dem im Zusammenhang mit Figur 3B beschriebenen vierten Ausführungsbeispiel des optoelektronischen Bauelements, das auch der Figur 4 zugrunde liegt.

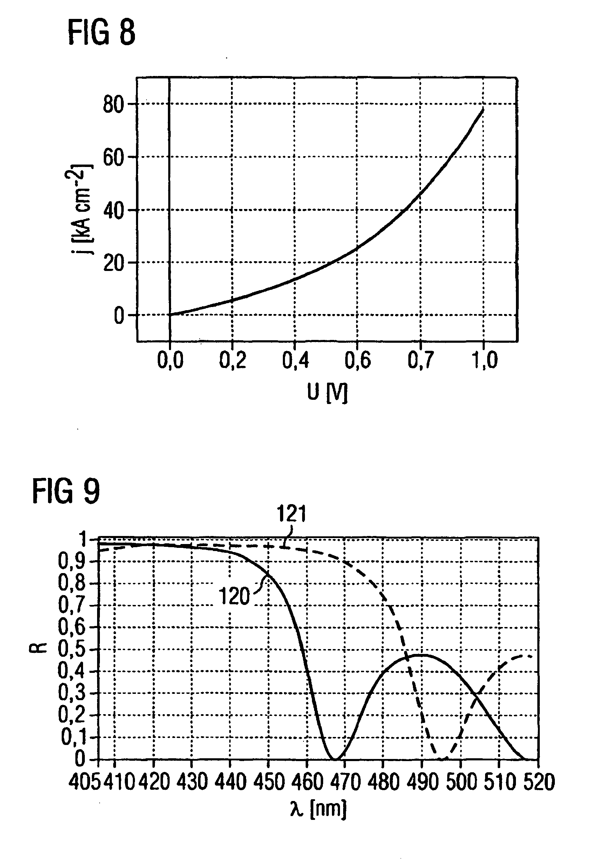

Die zugehörige Stromdichte j als Funktion des Spannungsabfalls U ist in Figur 8 gezeigt. Die Simulationen zeigen exemplarisch den Einfluss eines Emissionsbereichs 4, der drei Quantenschichten aufweist, wobei die Quantenschichten jeweils einen Indiumgehalt von 10 % aufweisen. Bedingt durch die Piezobarrieren, die an den Grenzflächen zwischen den indiumhaltigen Quantenschichten und den angrenzenden GaN-Schichten entstehen, kommt es zu einem zusätzlichen Spannungsabfall, wodurch sich die Betriebsspannung des optoelektronischen Bauelements erhöht.

Wie Figur 8 zeigt, beträgt dieser zusätzliche Spannungsabfall jedoch lediglich 1 V bei einer Stromdichte von 80 kA/cm². Die Quantenschichten des Emissionsbereichs 4 führen also trotz des hohen Indiumgehalts nur zu einer geringen Erhöhung der Betriebsspannung und somit nicht zu einer wesentlichen Beeinträchtigung der optoelektronischen Eigenschaften des optoelektronischen Bauelements.

In Figur 9 sind Ergebnisse von Simulationen der Reflektivität R als Funktion der Wellenlänge λ für zwei verschiedene Ausführungsbeispiele der Auskoppelschicht dargestellt. Die Auskoppelschichten sind jeweils mehrschichtig ausgebildet und in der Form von Bragg-Spiegeln ausgeführt. Die dargestellten Kurven 120 und 121 weisen jeweils in einem Wellenlängenbereich von 405 nm bis 470 nm eine sehr hohe Reflektivität von mindestens 90 % auf. Bei einer Wellenlänge von 520 nm ist die Reflektivität im Falle der Kurve 120 nahe 0 %, während die Reflektivität bei der Kurve 121 etwa 50 % beträgt. Die dargestellten Simulationen zeigen, dass durch Variation der Schichtdicken des Bragg-Spiegels der Auskoppelschicht die Strahlungsdurchtrittsfläche so ausgeführt werden kann, dass sie für Pumpstrahlung im blauen oder ultravioletten Spektralbereich eine sehr hohe Reflektivität aufweist. Gleichzeitig kann die Reflektivität für die Emissionsstrahlung angepasst an die Anforderungen des optoelektronischen Bauelements über weite Bereiche eingestellt werden.

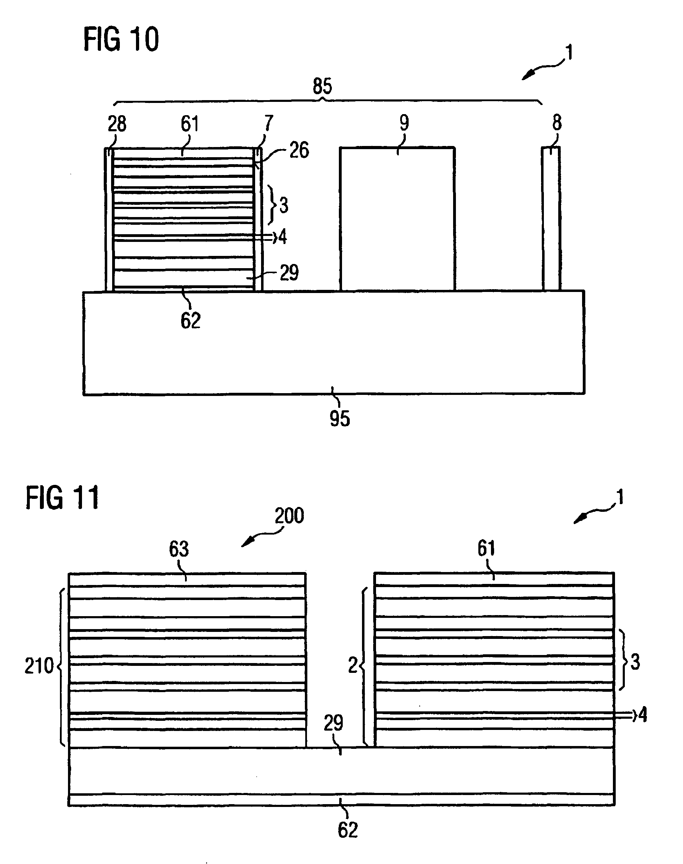

Ein fünftes Ausführungsbeispiel für ein optoelektronisches Bauelement ist in Figur 10 schematisch dargestellt. Der Halbleiterkörper 2 mit der Halbleiterschichtenfolge kann hierbei insbesondere wie im Zusammenhang mit den Figuren 1, 2, 3A oder 3B beschrieben ausgeführt sein. Das dargestellte optoelektronische Bauelement 1 weist einen externen Spiegel 8 auf, der als Endspiegel des Resonators 85 dient. Der Resonator 85 ist also als externer Resonator ausgeführt.

Der Halbleiterkörper 2 und der externe Spiegel 8 sind auf einem Montageträger 95 angeordnet und vorzugsweise mechanisch stabil mit diesem verbunden.

Der externe Spiegel 8 ist von dem Halbleiterkörper 2 beabstandet. Die Emissionsstrahlung durchläuft also einen Freistrahlbereich von dem Halbleiterkörper 2 zu dem externen Spiegel 8. In diesem Freistrahlbereich kann ein nichtlinear-optisches Element 9, etwa ein nichtlinear-optischer Kristall, angeordnet sein. Mittels dieses nichtlinear-optischen Elements kann die Emissionsstrahlung und/oder die Pumpstrahlung durch nichtlinear-optische Frequenzmischung, insbesondere Frequenzvervielfachung, etwa Frequenzverdopplung, in Strahlung anderer Wellenlängen konvertiert werden. Beispielsweise kann grüne Strahlung mit einer Wellenlänge von 532 nm in ultraviolette Strahlung mit einer Wellenlänge von 266 nm frequenzverdoppelt werden.

In dem gezeigten Ausführungsbeispiel kann die Strahlungsdurchtrittsfläche 26 des Halbleiterkörpers derart ausgeführt sein, dass sie für die Pumpstrahlung hoch reflektierend ist und für die Emissionsstrahlung eine sehr geringe Reflektivität, etwa 20 % oder weniger, bevorzugt 10 % oder weniger aufweist. Die Strahlungsdurchtrittsfläche 26 kann auf diese Weise für die Pumpstrahlung eine Resonatorendfläche darstellen, während für die Emissionsstrahlung der externe Spiegel 8 die Resonatorendfläche bildet. Die Emissionsstrahlung und die Pumpstrahlung können also in Resonatoren mit unterschiedlicher Länge oszillieren. Von dem gezeigten Ausführungsbeispiel abweichend kann die Emissionsstrahlung auch in einem anderen Resonatortyp, etwa einem Ringresonator oszillieren. In diesem Fall kann die der Strahlungsdurchtrittsfläche 26 gegenüberliegende Seitenfläche des Halbleiterkörpers für die Emissionsstrahlung eine vergleichsweise geringe Reflektivität, etwa 20 % oder weniger, bevorzugt 10 % oder weniger, aufweisen.

Ein sechstes Ausführungsbeispiel für ein optoelektronisches Bauelement ist in Figur 11 schematisch in Seitenansicht dargestellt. Zusätzlich zu dem Halbleiterkörper 2 mit dem Emissionsbereich 4 und dem Pumpbereich 3 weist dieses optoelektronische Bauelement einen Strahlungsempfänger 200 auf.

Dieser Strahlungsempfänger 200 umfasst eine weitere Halbleiterschichtenfolge 210. Der Schichtaufbau dieser weiteren Halbleiterschichtenfolge, insbesondere deren strahlungsempfindlicher Bereich, entspricht zumindest teilweise dem Schichtaufbau der Halbleiterschichtenfolge mit dem Emissionsbereich 4 und dem Pumpbereich 3. Die Halbleiterschichtenfolge für den Strahlungsempfänger 200 sowie die Halbleiterschichtenfolge mit dem Pumpbereich 3 und dem Emissionsbereich 4 können also in einem gemeinsamen Abscheideschritt, etwa mittels MOCVD oder MBE, hergestellt werden.

Der Strahlungsempfänger 200 und der Halbleiterkörper 2 mit dem Emissionsbereich und dem Pumpbereich können auf einem gemeinsamen Träger 29, der mittels des Aufwachssubstrats für die Halbleiterschichtenfolge gebildet sein kann, angeordnet sein. In einem derartigen optoelektronischen Bauelement können also der Emissionsbereich 4, der Pumpbereich 3 und ein strahlungsempfindlicher Bereich eines Strahlungsempfängers 200 monolithisch integriert sein.

Auf der dem Träger 29 abgewandten Seite weist der Strahlungsempfänger eine Kontaktschicht 63 auf. Die Kontaktschicht des Strahlungsempfängers kann zusammen mit der Kontaktschicht 61 abgeschieden werden.

Im Betrieb des optoelektronischen Bauelements 1 kann zwischen der Kontaktschicht 63 und der zweiten Kontaktschicht 62 ein Detektionssignal abgegriffen werden.

Mittels des Strahlungsempfängers 200 kann beispielsweise die Intensität der Emissionsstrahlung und/oder der Pumpstrahlung überwacht werden. Auf ein zusätzliches optoelektronisches Bauteil kann hierfür verzichtet werden.

Diese Patentanmeldung beansprucht die Priorität der deutschen Patentanmeldungen 10 2007 045 463.7 und 10 2007 058 952.4.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder den Ausführungsbeispielen angegeben ist.

## Patentansprüche

1. Optoelektronisches Bauelement (1), das einen Halbleiterkörper (2) mit einer Halbleiterschichtenfolge aufweist, wobei
- die Halbleiterschichtenfolge des Halbleiterkörpers (2) einen zur Erzeugung einer Pumpstrahlung vorgesehenen Pumpbereich (3) und einen zur Erzeugung einer Emissionsstrahlung vorgesehenen Emissionsbereich (4) aufweist;
- der Pumpbereich (3) und der Emissionsbereich (4) übereinander angeordnet sind;
- der Emissionsbereich (4) und der Pumpbereich (3) zwischen zwei Mantelschichten (20, 23) angeordnet sind, so dass die Mantelschichten (20, 23) eine gemeinsame transversale Wellenführung der Pumpstrahlung und der Emissionsstrahlung bewirken;
- die Emissionsstrahlung und die Pumpstrahlung kollinear verlaufen;
- die Pumpstrahlung den Emissionsbereich (4) im Betrieb des optoelektronischen Bauelements (1) optisch pumpt; und
- die Emissionsstrahlung im Betrieb des optoelektronischen Bauelements (1) in lateraler Richtung aus dem Halbleiterkörper (2) austritt.

2. Optoelektronisches Bauelement nach Anspruch 1,
bei dem die Emissionsstrahlung und die Pumpstrahlung in lateraler Richtung propagieren.

3. Optoelektronisches Bauelement nach einem der Ansprüche 1 bis 2,
in dessen Betrieb der Pumpbereich (3) elektrisch gepumpt wird, wobei Ladungsträger eines Ladungstyps durch den Emissionsbereich (4) hindurch in den Pumpbereich (3) injiziert werden.

4. Optoelektronisches Bauelement nach einem der vorangehenden Ansprüche,
bei dem der Emissionsbereich (4) und/oder der Pumpbereich (3) eine Quantenstruktur aufweist, wobei der Emissionsbereich (4) und der Pumpbereich (3) jeweils eine Quantenschicht (31, 41) aufweisen und eine Bandlücke einer an die Quantenschicht (41) des Emissionsbereichs (4) angrenzenden Halbleiterschicht (5, 21) einer Bandlücke einer an die Quantenschicht (31) des Pumpbereichs (3) angrenzenden Halbleiterschicht (32, 22, 5) entspricht.

5. Optoelektronisches Bauelement nach einem der vorangehenden Ansprüche,
bei dem in dem Halbleiterkörper (2) eine Ladungsträgerbarriere (50) ausgebildet ist.

6. Optoelektronisches Bauelement nach Anspruch 5,
bei dem die Ladungsträgerbarriere (50) als eine Tunnelbarriere (51) ausgeführt ist.

7. Optoelektronisches Bauelement nach Anspruch 5 oder 6,
bei dem die Ladungsträgerbarriere (50) zwischen dem Emissionsbereich (4) und dem Pumpbereich (3) angeordnet ist.

8. Optoelektronisches Bauelement nach einem der vorangehenden Ansprüche,
bei dem ein Abstand zwischen dem Emissionsbereich (4) und dem Pumpbereich (3) derart eingestellt ist, dass ein vorgegebener Anteil der Pumpstrahlung mit dem Emissionsbereich (4) optisch koppelt.

9. Optoelektronisches Bauelement nach einem der vorangehenden Ansprüche,
bei dem der Emissionsbereich (4) und der Pumpbereich (3) in vertikaler Richtung jeweils für den Betrieb in einer optischen Mode derselben Ordnung vorgesehen sind.

10. Optoelektronisches Bauelement nach einem der Ansprüche 1 bis 8,
bei dem der Emissionsbereich (4) und der Pumpbereich (3) in vertikaler Richtung für den Betrieb in optischen Moden mit voneinander verschiedenen Ordnungen vorgesehen sind.

11. Optoelektronisches Bauelement nach einem der vorangehenden Ansprüche,
bei dem der Emissionsbereich (4) und/oder der Pumpbereich (3) ein III-V-Halbleitermaterial, insbesondere AlₓIn_{y}Ga_{1-x-y}N, AlₓIn_{y}Ga_{1-x-y}Sb, AlₓIn_{y}Ga_{1-x-y}As oder AlₓIn_{y}Ga_{1-x-y}P, jeweils mit 0 ≤ x ≤ 1, 0 ≤ y ≤ 1 und x + y ≤ 1, oder ein III-V-Halbleitermaterial mit einem Stickstoff-Gehalt von höchstens 5 %, enthält.

12. Optoelektronisches Bauelement nach einem der vorangehenden Ansprüche,
bei dem der Halbleiterkörper (2) eine Strahlungsdurchtrittsfläche (26) aufweist, die derart ausgebildet ist, dass sie für die Emissionsstrahlung eine niedrigere Reflektivität aufweist als für die Pumpstrahlung.

13. Optoelektronisches Bauelement nach einem der Ansprüche 1 bis 12,
bei dem der Halbleiterkörper (2) eine Strahlungsdurchtrittsfläche (26) aufweist, durch die die Emissionsstrahlung (4) und die Pumpstrahlung (3) kollinear hindurch treten.

14. Optoelektronisches Bauelement nach einem der vorhergehenden Ansprüche,
das einen Strahlungsempfänger (200) aufweist, wobei der Strahlungsempfänger (200) eine weitere Halbleiterschichtenfolge (210) aufweist, wobei die Halbleiterschichtenfolge und die weitere Halbleiterschichtenfolge aus einer gemeinsamen Halbleiterschichtenfolge hervorgehen, so dass der Schichtaufbau der Halbleiterschichtenfolge des Strahlungsempfängers zumindest teilweise dem Schichtaufbau der Halbleiterschichtenfolge mit dem Pumpbereich (3) und dem Emissionsbereich (4) entspricht.

15. Optoelektronisches Bauelement nach einem der vorhergehenden Ansprüche,
bei dem der Emissionsbereich AlInGaN enthält und die Emissionsstrahlung im grünen Spektralbereich zwischen einschließlich 490 nm und einschließlich 570 nm liegt.

## Claims

1. Optoelectronic component (1) comprising a semiconductor body (2) having a semiconductor layer sequence, wherein
- the semiconductor layer sequence of the semiconductor body (2) comprises a pump region (3) provided for generating a pump radiation and an emission region (4) provided for generating an emission radiation;
- the pump region (3) and the emission region (4) are arranged one above the other;
- the emission region (4) and the pump region (3) are arranged between two cladding layers (20, 23), such that the cladding layers (20, 23) bring about a common transverse waveguiding of the pump radiation and of the emission radiation;
- the emission radiation and the pump radiation pass collinearly;
- the pump radiation optically pumps the emission region (4) during the operation of the optoelectronic component (1); and
- the emission radiation emerges from the semiconductor body (2) in a lateral direction during the operation of the optoelectronic component (1).

2. Optoelectronic component according to Claim 1,
wherein the emission radiation and the pump radiation propagate in a lateral direction.

3. Optoelectronic component according to either of Claims 1 and 2,
during the operation of which the pump region (3) is electrically pumped, wherein charge carriers of one charge type are injected through the emission region (4) into the pump region (3).

4. Optoelectronic component according to any of the preceding claims,
wherein the emission region (4) and/or the pump region (3) have/has a quantum structure, wherein the emission region (4) and the pump region (3) in each case have a quantum layer (31, 41), and a band gap of a semiconductor layer (5, 21) adjoining the quantum layer (41) of the emission region (4) corresponds to a band gap of a semiconductor layer (32, 22, 5) adjoining the quantum layer (31) of the pump region (3).

5. Optoelectronic component according to any of the preceding claims,
wherein a charge carrier barrier (50) is formed in the semiconductor body (2).

6. Optoelectronic component according to Claim 5,
wherein the charge carrier barrier (50) is embodied as a tunnel barrier (51).

7. Optoelectronic component according to Claim 5 or 6,
wherein the charge carrier barrier (50) is arranged between the emission region (4) and the pump region (3).

8. Optoelectronic component according to any of the preceding claims,
wherein a distance between the emission region (4) and the pump region (3) is set in such a way that a predefined proportion of the pump radiation optically couples to the emission region (4).

9. Optoelectronic component according to any of the preceding claims,
wherein the emission region (4) and the pump region (3) are provided in a vertical direction in each case for operation in an optical mode of the same order.

10. Optoelectronic component according to any of Claims 1 to 8,
wherein the emission region (4) and the pump region (3) are provided in a vertical direction for operation in optical modes having mutually different orders.

11. Optoelectronic component according to any of the preceding claims,
wherein the emission region (4) and/or the pump region (3) contain(s) a III-V semiconductor material, in particular AlₓIn_{y}Ga_{1-x-y}N, AlₓIn_{y}Ga_{1-x-y}Sb, AlₓIn_{y}Ga_{1-x-y}As or AlₓIn_{y}Ga_{1-x-y}P, in each case where 0 ≤ x ≤ 1, 0 ≤ y ≤ 1 and x + y ≤ 1, or a III-V semiconductor material having a nitrogen content of at most 5%.

12. Optoelectronic component according to any of the preceding claims,
wherein the semiconductor body (2) has a radiation passage surface (26) embodied in such a way that it has a lower reflectivity for the emission radiation than for the pump radiation.

13. Optoelectronic component according to any of Claims 1 to 12,
wherein the semiconductor body (2) has a radiation passage surface (26) through which the emission radiation (4) and the pump radiation (3) pass collinearly.

14. Optoelectronic component according to any of the preceding claims,
which comprises a radiation receiver (200), wherein the radiation receiver (200) comprises a further semiconductor layer sequence (210), wherein the semiconductor layer sequence and the further semiconductor layer sequence emerge from a common semiconductor layer sequence, such that the layer construction of the semiconductor layer sequence of the radiation receiver at least partly corresponds to the layer construction of the semiconductor layer sequence having the pump region (3) and the emission region (4).

15. Optoelectronic component according to any of the preceding claims,
wherein the emission region contains AlInGaN and the emission radiation is in the green spectral range between 490 nm and 570 nm inclusive.

## Revendications

1. Composant optoélectronique (1) comportant un corps semi-conducteur (2) avec une série de couches semi-conductrices, dans lequel
- la série de couches semi-conductrices du corps semi-conducteur (2) comporte une région de pompage (3) conçue pour générer un rayonnement de pompage et une région d'émission (4) conçue pour générer un rayonnement d'émission ;
- la région de pompage (3) et la région d'émission (4) sont superposées l'une à l'autre ;
- la région d'émission (4) et la région de pompage (3) sont agencées entre deux couches extérieures (20, 23), de sorte que les couches extérieures (20, 23) assurent un guidage d'onde transversal conjoint du rayonnement de pompage et du rayonnement d'émission ;
- le rayonnement d'émission et le rayonnement de pompage évoluent de façon colinéaire ;
- le rayonnement de pompage pompe optiquement la région d'émission (4) pendant le fonctionnement du composant optoélectronique (1) ; et
- le rayonnement d'émission sort du corps semi-conducteur (2) dans la direction latérale pendant le fonctionnement du composant optoélectronique (1).

2. Composant optoélectronique selon la revendication 1, dans lequel le rayonnement d'émission et le rayonnement de pompage se propagent dans la direction latérale.

3. Composant optoélectronique selon l'une des revendications 1 et 2, pendant le fonctionnement duquel la région de pompage (3) est pompée électriquement, des porteurs de charge d'un type de charge étant injectés à travers la région d'émission (4) et dans la région de pompage (3).

4. Composant optoélectronique selon l'une des revendications précédentes, dans lequel la région d'émission (4) et/ou la région de pompage (3) présentent une structure quantique, la région d'émission (4) et la région de pompage (3) présentant respectivement une couche quantique (31, 41), et une bande interdite d'une couche semi-conductrice (5, 21) adjacente à la couche quantique (41) de la région d'émission (4) correspond à une bande interdire d'une couche semi-conductrice (32, 22, 5) adjacente à la couche quantique (31) de la région de pompage (3).

5. Composant optoélectronique selon l'une des revendications précédentes, dans lequel une barrière de porteur de charge (50) est formée dans le corps semi-conducteur (2).

6. Composant optoélectronique selon la revendication 5, dans lequel la barrière de porteur de charge (50) est conçue comme une barrière à tunnel (51).

7. Composant optoélectronique selon la revendication 5 ou 6, dans lequel la barrière de porteur de charge (50) est agencée entre la région d'émission (4) et la région de pompage (3).

8. Composant optoélectronique selon l'une des revendications précédentes, dans lequel un espacement entre la région d'émission (4) et la région de pompage (3) est réglée de manière à ce qu'une part prédéfinie du rayonnement de pompage s'accouple optiquement avec la région d'émission (4).

9. Composant optoélectronique selon l'une des revendications précédentes, dans lequel la région d'émission (4) et la région de pompage (3) sont prévues dans le sens vertical respectivement pour le fonctionnement d'un mode optique selon un même ordre.

10. Composant optoélectronique selon l'une des revendications 1 à 8, dans lequel la région d'émission (4) et la région de pompage (3) sont prévues dans le sens vertical pour le fonctionnement dans des modes optiques selon des ordres différents les uns des autres.

11. Composant optoélectronique selon l'une des revendications précédentes, dans lequel la région d'émission (4) et/ou la région de pompage (3) contient un matériau semi-conducteur III-V, en particulier AlₓIn_{y}Ga_{1-x-y}N, AlₓIn_{y}Ga_{1-x-y}Sb, AlₓIn_{y}Ga_{1-x-y}As ou AlₓIn_{y}Ga_{1-x-y}P, respectivement avec 0 ≤ x ≤ 1, 0 ≤ y ≤ 1 et x + y ≤ 1, ou un matériau semi-conducteur III-V avec une part d'azote de 5% maximum.

12. Composant optoélectronique selon l'une des revendications précédentes, dans lequel le corps semi-conducteur (2) présente une surface de passage de rayonnement (26) conçue de manière à présenter une réflectivité plus faible pour le rayonnement d'émission que pour le rayonnement de pompage.

13. Composant optoélectronique selon l'une des revendications 1 à 12, dans lequel le corps semi-conducteur (2) présente une surface de passage de rayonnement (26) traversée de façon colinéaire par le rayonnement d'émission (4) et par le rayonnement de pompage (3).

14. Composant optoélectronique selon l'une des revendications précédentes, comprenant un récepteur de rayonnement (200), le récepteur de rayonnement (200) comprenant une série supplémentaire de couches semi-conductrices (210), la série de couches semi-conductrices et la série supplémentaire de couches semi-conductrices étant issues d'une même série de couches semi-conductrices, de manière à ce que la structure de couches de la série de couches semi-conductrices du récepteur de rayonnement corresponde au moins partiellement à la structure de couches de la série de couches semi-conductrices avec la région de pompage (3) et la région d'émission (4).

15. Composant optoélectronique selon l'une des revendications précédentes, dans lequel la région d'émission contient du AlInGaN, et le rayonnement d'émission est compris dans la plage spectrale verte de 490 nm à 570 nm, bornes incluses.
